Europäisches Patentamt

European Patent Office

Office européen des brevets

(19)

(11) Publication number: **0 176 203 B1**

(12) **EUROPEAN PATENT SPECIFICATION**

(45) Date of publication of patent specification: **18.12.91** (51) Int. Cl.⁵: **G11C 11/406**

(21) Application number: **85305697.6**

(22) Date of filing: **12.08.85**

(54) **Self refresh control circuit for dynamic semiconductor memory device.**

(30) Priority: **20.08.84 JP 172754/84**

(43) Date of publication of application:
**02.04.86 Bulletin 86/14**

(45) Publication of the grant of the patent:
**18.12.91 Bulletin 91/51**

(84) Designated Contracting States:
**DE FR GB**

(56) References cited:
**EP-A- 0 128 427**
**US-A- 3 796 998**
**US-A- 4 393 477**

**PATENT ABSTRACTS OF JAPAN, vol. 8, no. 159 (P-289)[1596], 24th July 1984; & JP-A-59 56 291 (HITACHI SEISAKUSHO K.K.) 31-03-1984**

(73) Proprietor: **KABUSHIKI KAISHA TOSHIBA 72, Horikawa-cho Saiwai-ku Kawasaki-shi Kanagawa-ken(JP)**

(72) Inventor: **Sakurai, Takayasu c/o Patent Division Toshiba Corp. Principal Off. 1-1, Shibaura 1-chome Minato-ku Tokyo(JP)**
Inventor: **Iizuka, Tetsuya c/o Patent Division Toshiba Corp. Principal Off. 1-1, Shibaura 1-chome Minato-ku Tokyo(JP)**

(74) Representative: **Shindler, Nigel et al BATCHELLOR, KIRK & CO. 2 Pear Tree Court Farringdon Road London EC1R 0DS(GB)**

EP 0 176 203 B1

## Description

This invention relates to a self-refresh control circuit of a semiconductor memory device, particularly a Dynamic Random Access Memory device (DRAM).

Recent advances in semiconductor dynamic memory device technology enable a self-refresh circuit to be incorporated on a single chip having memory cells, which can perform a self-refresh operation automatically by itself and eliminate the need for timing or address control circuits outside the chip.

In general, this type of self-refresh circuit includes an oscillator and refresh address counter, which are provided for designating the address of memory cells during the refresh operation when the memory cells are on "standby" operation or not in the read or write operation.

In these circuits, the oscillator circuit which determines the frequency of refresh operation, comprises MOS-FETS. Generally, the speed of operation of a MOS-FET becomes lower as temperature increases. Thus the frequency of the oscillator decreases at high temperatures.

On the other hand, the current leakage of a memory cell approximately doubles when the temperature rises by 10°. Accordingly, the frequency of the oscillator is set high enough so as to operate satisfactorily even at high temperatures. The result is that the frequency of the refresh operation at low temperatures is higher than required.

Further, the integrated circuits which have passed through various manufacturing processes, have some distributed characteristics. Therefore, it is necessary to set up the frequency of the oscillator with sufficient margin.

Accordingly, in general, the frequency is set about 100 times as high as is actually needed in ordinary temperature.

The refresh operation involves a certain power consumption. For example, 256K DRAM consumes several milliamperes of current on standby operation. Because of this high power consumption, it is very difficult to operate DRAMS using a dry battery as a power source.

In order to eliminate these disadvantages of DRAMS Japanese Laid Open Patent 59-56291 provides a memory device which automatically controls the frequency of the refresh operation to be as much as needed so as to reduce the power consumption. This refresh control circuit comprises two leakage current monitor capacitors, each of which is precharged to some respective predetermined level, and a voltage comparator circuit for detecting the voltage difference between the two capacitors and causing a refresh operation when required in accordance with the voltage difference.

However, this refresh control circuit still has the following problems. First, it is very difficult to design the characteristics of two capacitors such as current leakage time or initially charged voltages to provide a proper simulation of memory cells because the leak current monitoring system does not detest the current leakage time of the capacitor itself but the difference of two capacitors. Therefore, unless the characteristics are arranged appropriately, it is not necessarily possible to monitor the current leakage time of memory cells exactly. Second, the comparator circuit still wastes power because a current flows throughout the circuit. This reduces the primary advantage of this circuit.

U.S. Patent No. 3,796,998 and European application no. 01 28 427 published on 19th December 1984 i.e. after the priority date of the present application also disclose refresh control circuits including leakage current monitoring.

The present invention therefore seeks to provide a self-refresh control circuit for dynamic semiconductor memory devices in which the power consumption of the memory device on standby operation can be minimised.

The present invention also seeks to provide a self-refresh control circuit in which the power consumption of the control circuit itself is small.

The present invention further seeks to provide a self- refresh control circuit by means of which the stored information of DRAM can be maintained by a dry battery voltage source.

Accordingly, a first aspect of the present invention provides a dynamic semiconductor memory device having a plurality of memory cells, and a refresh control circuit comprising:

a leakage current monitoring means including a capacitor having a similar leakage characteristic to a memory cell, capacitor charging means connected to said capacitor for charging said capacitor to a first predetermined voltage in response to a timing pulse and a refresh timing and address control means including an oscillator, a row address counter, and a level detection circuit connected between said capacitor and said oscillator so as to start the oscillator after the capacitor voltage has fallen below a second predetermined level, so as to generate a series of pulses which are supplied to the row address counter to enable the refresh of each corresponding address in turn, and reset means arranged to produce said timing pulse after all the rows have been refreshed.

A further aspect of the invention provides a dynamic semiconductor memory device having a plurality of memory cells, and a refresh control circuit comprising:

a leakage current monitoring means including a capacitor having a similar leakage characteristic to a memory cell, capacitor charging means connected to said capacitor for charging said capacitor to a first predetermined voltage in response to a timing pulse, an inverter connected to the output of said leakage monitoring circuit, a row address counter driven from the output of said inverter and a delay circuit connected to the output of said inverter to produce said timing pulse for the capacitor after its voltage has fallen to a predetermined level, whereby the frequency of pulses supplied to the row address counter from the inverter is dependent upon the discharge rate of the capacitor.

Some embodiments of the invention will now be described by way of example with reference to the accompanying drawings in which:

Figure 1 shows a block diagram of a preferred embodiment of the invention;

Figure 2 shows a timing chart diagram of the circuit of Figure 1;

Figure 3 shows an embodiment of the oscillator circuit of Figure 1;

Figure 4 shows another embodiment of the invention;

Figure 5 shows a timing chart diagram of the circuit of Figure 4; and

Figure 6 shows another embodiment of the leak current monitor circuit and inverter circuit of the invention.

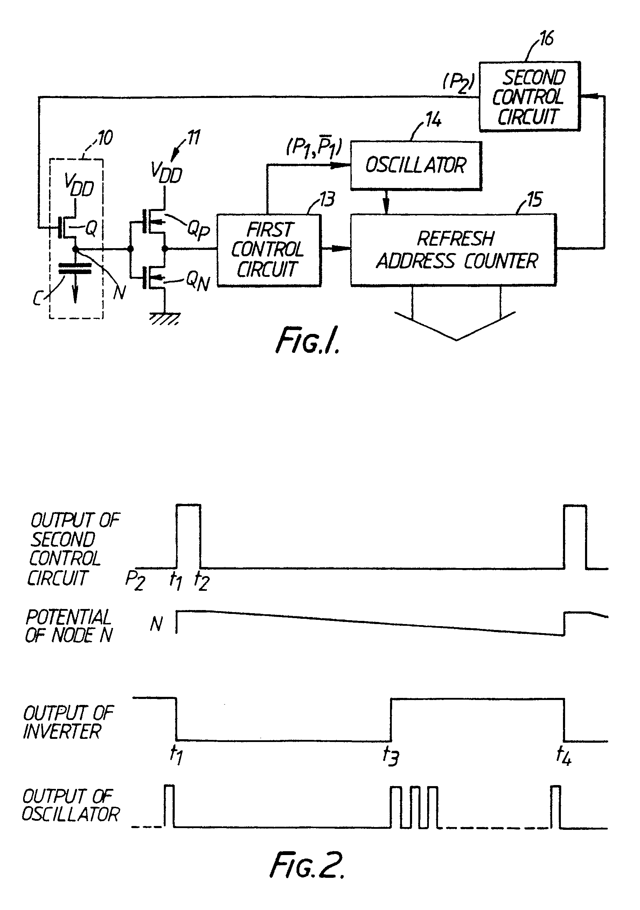

The automatic self-refresh control circuit for a dynamic memory shown in Figure 1 includes one capacitor serially connected to one transfer gate.

The circuit comprises leak current monitor circuit 10 having a capacitor C serially connected to a transfer gate Q between a voltage source $V_{DD}$ and a constant voltage terminal (in this case, an earth terminal).

CMOS inverter circuit 11 connected to the capacitor C has a N-type MOS transistor $Q_N$ and P-type MOS transistor $Q_P$ whose conductance is larger than $Q_N$. The threshold voltage Vth of this circuit is designed to be larger than $\frac{1}{2} V_{DD}$ by a predetermined level according to the difference in conductance of the transistors $Q_P$ and $Q_N$.

A first control circuit 13 receives the output signal of the CMOS inverter circuit and waveshapes it as an output signal applied to a self-excited oscillator 14 which is thus set into oscillation by the signal.

A refresh address counter 15 is put into a reset mode by receiving the output signal from the control circuit 13 and counts the output signal from the oscillator 14 to make a refresh address signal which is sent to a row decoder which drives a word line selectively.

A second control circuit 16 receives an overflow signal from the counter which generates a pulse output having a constant width when the count exceeds the number of all word lines. This pulse signal puts the transfer gate into the ON state and charges the capacitor C.

The operation of the circuit will now be described with reference to Figure 2. First, the output signal of the second control circuit 16 puts the transfer gate Q into the ON state in the period t1 to t2 and charges the capacitor C. The connecting point of Q and C, i.e. the node N, is thus charged up to "1" level.

The potential level of this node N is intended to represent the leakage of a memory cell of the dynamic memory. That is to say, if the leakage current of the memory cell is larger, the potential level of the node N should fall to zero volts more quickly and if the leakage current is smaller, it should fall more slowly. At time t3 when the potential level decreases below the level of the threshold voltage Vth, the output signal of the inverter circuit 11 changes to "1" level from "0" level and this signal is shaped by the first control circuit 13. The output signal of the control circuit 13 puts the refresh address counter 15 into the reset mode and starts the oscillator 14.

Accordingly, the oscillator 14 begins to generate pulse signals, which are counted by the counter 15 in order to produce the refresh addresses. At time t4, when the counter 15 overflows, an overflow signal is applied to the second control circuit 16 which generates a further pulse signal having a constant width to drive the transfer gate Q and charge the capacitor C again.

In the above sequence of operation, it is necessary that the time during which the potential level of the node N in the leak current monitor circuit 10 changes to the Vth level, which is the threshold voltage of the CMOS inverter circuit 11, from the precharged level, is shorter than the time which would be taken for the information stored in a capacitor of memory cell to be lost. For this purpose, the Vth of the CMOS inverter circuit 11 is designed to be higher than $\frac{1}{2} V_{DD}$.

In this embodiment of the invention, the refresh operation is performed in a short period if the leakage current of memory cell is large, and in a longer period if the leakage current is small. Accordingly, it is possible to control the period of the refresh operation to the most desirable value by monitoring the leakage current of a memory cell.

Further, it is unnecessary to set up the refresh frequency with a high margin. Consequently, the frequency can be set to about 1/100 of that of a conventional circuit. In this way the power consumption at a stand-by state can be minimised. In addition, no direct current path needs to be provided through the CMOS inverter circuit 11 for monitoring the leakage current and the power consumption of the circuit is small, so it is possible to construct a DRAM which can operate with a dry battery as a power source.

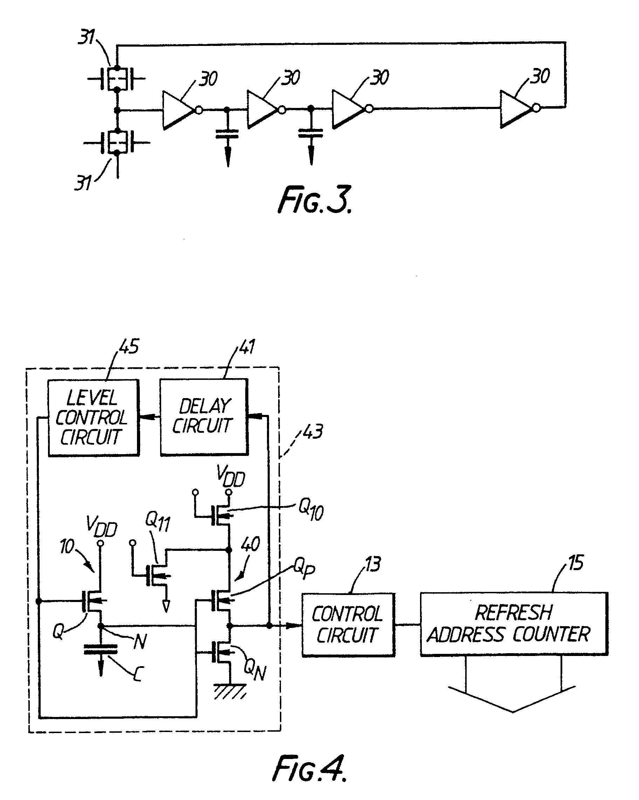

Figure 3 shows one embodiment of the oscillator 14. This circuit comprises a plurality of CMOS inverter circuits connected in a ring and transfer gates 31, 32 having inputs receiving complimentary control signals from the first control circuit 13 respectively. These transfer gates 31, 32 control whether the circuit starts to oscillate or not.

The embodiment of Figure 1 shows an example of an intermittent type refresh circuit. This circuit monitors the change of potential of the capacitor C and starts the oscillator 14 when the voltage decreases under some predetermined level. Then the memory cells are all refreshed one after another. That is to say, the refresh operation is performed intermittently.

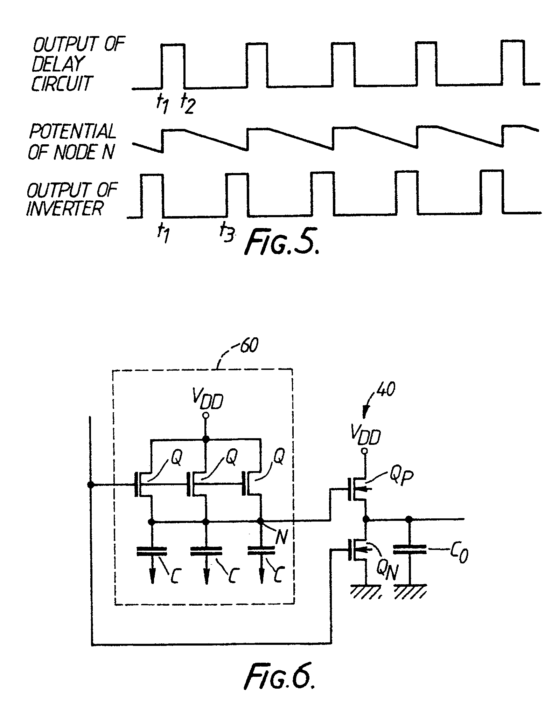

An alternative embodiment of this invention shown in Figure 4 represents a distributed type refresh circuit. This circuit employs a precharge-discharge type inverter circuit 40 which receives an output signal from the leakage monitor circuit 10 and generates a signal to the control terminal of the transfer gate Q of the leakage monitor circuit 10 through a delay circuit 41 and a level control circuit 45 so as to make a closed loop circuit which operates as an oscillator. The operation of this circuit will be described with reference to Figure 5.

From time t1 to t2, the capacitor C is charged and the N-channel transistor $Q_N$ switches ON so that the output of the inverter changes to "0". At time t3 when the charged voltage of the capacitor decreases below a predetermined level as a result of its leakage current, the P-channel transistor $Q_P$ switches ON and the output of the inverter changes to "1". This "1" signal starts the charging of the capacitor C again after a delay set by the delay circuit 41. The repetition of this sequence makes an oscillation.

In this case, the leakage of the capacitor C corresponds to that of a memory cell. By setting the threshold voltage of the inverter circuit 40 to be a little higher, it is possible to establish the frequency of the oscillator at a desired value for the actual memory cells. The output signal of the inverter 40 is shaped by the control circuit 13 and counted by the refresh address counter 15.

Although the inverter 40 includes additional transistors Q10 and Q11, the circuit certainly operates as an inverter. These transistors Q10 and Q11 are used to control the threshold voltage of the inverter circuit 40.

This precharge-discharge type inverter circuit has an advantage such that the power consumption is less than that of an ordinary inverter circuit because the transistors $Q_P$ and $Q_N$ do not come ON at the same time and no current path is formed between the voltage source $V_{DD}$ and the earth terminal.

The level control circuit 45 is used to control the initial charged up voltage level of the node N. This circuit may not always necessarily be employed.

The capacitor C can be such as to have a slightly higher leakage current than an ordinary memory cell capacitor. For example, the impurity concentration of the surface portion of the semiconductor body which acts as an electrode of the capacitor is made a little higher, or a polysilicon conductor which acts as an electrode of the capacitor is formed like a comb. This technique helps to perform the refresh operation with a safe margin.

Figure 6 shows another embodiment of the leak monitor circuit according to the invention in place of the circuit 10 and CMOS inverter 11 of Figure 1.

This circuit comprises a leak monitor circuit 60 and a precharge-discharge type inverter 40.

The leak monitor circuit 60 may include three monitor cells, each of which has a transfer-gate Q and a capacitor C connected thereto. These monitor cells are connected in parallel. The node N of these cells are connected to the gate electrode of a P-channel transistor $Q_P$ of the inverter circuit 40. The gate of a N-channel transistor $Q_N$ of the inverter circuit 40 is connected to the input terminal of the leak monitor circuit 60. The capacitor Co is employed to stabilise the potential level of the output node of the inverter circuit 40.

In this embodiment, the number of monitor capacitors is not limited to three. For example, a hundred capacitors may be available. By increasing the number of capacitors, the errors due to the gate capacitance of the transistor $Q_P$ which monitors the charge stored in the capacitors can be reduced. However, it should be noted that the leakage time of the capacitor is not dependent on the number of parallel-connected capacitors.

## Claims

1. A dynamic semiconductor memory device having a plurality of memory cells, and a refresh control circuit comprising:

   a leakage current monitoring means (10,60) including a capacitor (C) having a similar leakage characteristic to a memory cell, capacitor charging means (Q) connected to said capacitor for charging said capacitor to a first predetermined voltage (VDD) in response to a timing pulse (P2) and a refresh timing and address control means including an oscillator (14), a refresh address counter (15), and a level detection circuit (11) connected between said capacitor and said oscillator so as to start the oscillator after the capacitor voltage has fallen below a second predetermined level, so as to generate a series of pulses which are supplied to the refresh address counter to enable the refresh of each corresponding address in turn, and reset means (16) arranged to produce said timing pulse after all the rows have been refreshed.

2. A dynamic semiconductor memory device according to claim 1 in which the reset means (16) is connected to the refresh address counter so as to operate in response to a predetermined output from said refresh address counter.

3. A dynamic semiconductor memory device according to claim 1 or 2 in which the level detection circuit comprises an inverter.

4. A dynamic semiconductor memory device having a plurality of memory cells, and a refresh control circuit comprising:

a leakage current monitoring means (10) including a capacitor (C) having a similar leakage characteristic to a memory cell, capacitor charging means (Q) connected to said capacitor for charging said capacitor to a first predetermined voltage (VDD) in response to a timing pulse, an inverter (40) connected to the output of said leakage monitoring circuit, a refresh address counter (15) driven from the output of said inverter and a delay circuit (41) connected to the output of said inverter to produce said timing pulse for the capacitor after its voltage has fallen to a predetermined level, whereby the frequency of pulses supplied to the refresh address counter from the inverter is dependent upon the discharge rate of the capacitor.

5. A dynamic semiconductor memory device according to claim 3 or claim 4 in which the inverter circuit comprises a precharge-discharge type inverter.

**Revendications**

1. Dispositif de mémoire dynamique à semiconducteurs comportant un certain nombre de cellules de mémoire et un circuit de commande de rafraîchissement, comprenant:

des moyens de contrôle des courants de fuite (10, 6O) incluant un condensateur (C) présentant des caractéristiques de fuite semblables à celles d'une cellule de mémoire, des moyens (Q) connectés audit condensateur afin de charger ce dernier à une première tension électrique prédéterminée (VDD) en réponse à une impulsion de chronologie ou de timing (P2) et des moyens de timing de rafraîchissement et de commande d'adresse incluant un oscillateur (14), un compteur d'adresse à rafraîchir (15) et un circuit de mesure de niveau (11) branché entre ledit condensateur et ledit oscillateur de façon à démarrer ce dernier après que la tension du condensateur est tombée au-dessous d'un second niveau prédéterminé, de manière à engendrer une série d'impulsions qui sont appliquées à un compteur d'adresse à rafraîchir afin de permettre de rafraîchir à son tour chacune de ces adresses, et des moyens de remise (16) à une position initiale conçus pour produire ladite impulsion de chronologie ou de timing après que toutes les rangées ont été rafraîchies.

2. Dispositif de mémoire dynamique à semiconducteurs selon la revendication 1, caractérisé en ce que les moyens de remise (16) sont connectés au compteur d'adresse à rafraîchir de manière à opérer en réponse à un signal de sortie prédéterminé dudit compteur.

3. Dispositif de mémoire dynamique à semiconducteurs selon la revendication 1 ou 2, caractérisé en ce que le circuit de mesure de niveau comprend un inverseur.

4. Dispositif de mémoire dynamique à semiconducteurs comportant plusieurs cellules de mémoire et un circuit de commande de rafraîchissement, qui comprend :

des moyens de contrôle ou de mesure des courants de fuite (10) incluant un condensateur (C) ayant des caractéristiques de fuite semblables à celle d'une cellule de mémoire, des moyens de charge (Q) connectés audit condensateur afin de le charger à une première tension prédéterminée (VDD) en réponse à une impulsion de chronologie ou de timing, un inverseur (10) connecté à la sortie dudit circuit de contrôle de fuites, un compteur d'adresse à rafraîchir (15) actionné par la sortie dudit inverseur et un circuit à retard (41) connecté à la sortie dudit inverseur afin de produire ladite impulsion de chronologie pour le condensateur après que sa tension est tombée à un niveau prédéterminé, ce qui fait que la fréquence des impulsions fournies au compteur d'adresse à rafraîchir par l'inverseur est dépendante de la vitesse de décharge du condensateur.

5. Dispositif de mémoire semi-conducteur selon la revendication 3 ou 4, caractérisé en ce que l'inverseur est du type à précharge et décharge.

**Patentansprüche**

1. Dynamische Halbleiterspeicheranordnung mit einer Vielzahl von Speicherzellen und einer Auffrischungssteuerschaltung, mit:

einer Leckstrom-Überwachungseinrichtung (10, 60) mit einem Kondensator (C), der eine ähnliche Leckstromcharakteristik wie eine Speicherzelle aufweist, einer Kondensator-Ladeeinrichtung (Q), die an den Kondensator angeschlossen ist und zum Aufladen des Kondensators bis zu einer ersten vorgegebenen Spannung (VDD) auf ein Zeitsignal (P2) hin dient, einer Auffrischungszeit- und Auffrischungsadreß-Steuereinrichtung mit einer Oszillator (14), einem Auffrischungsadressenzähler (15) und einer Höhennachweisschaltung (11), die zwischen den Kondensator und den Oszillator geschaltet ist, um den Oszillator zu starten, wenn die Kondensatorspannung unter eine zweite vorgegebene Höhe gefallen ist, um so eine Folge von Pulsen zu erzeugen, welche dem Auffrischungsadressenzähler zugeführt werden, um nacheinander die Auffrischung jeder Adresse zu ermöglichen, und einer Rücksetzeinrichtung (16), die dazu ausgelegt ist, das Zeitsignal zu erzeugen, nachdem alle Zeilen aufgefrischt sind.

2. Dynamische Halbleiterspeicheranordnung nach Anspruch 1, bei dem die Rücksetzeinrichtung (16) mit dem Auffrischungsadressenzähler verbunden ist, um auf eine vorgegebene Ausgabe des Auffrischungsadressenzählers hin zu arbeiten.

3. Dynamische Halbleiterspeicheranordnung nach Anspruch 1 oder 2, wobei die Höhennachweisschaltung einen Inverter enthält.

4. Dynamische Halbleiterspeicheranordnung mit einer Vielzahl von Speicherzellen und einer Auffrischungssteuerschaltung, mit:

einer Leckstrom-Überwachungseinrichtung (10) mit einem Kondensator (C), der eine ähnliche Leckstromcharakteristik wie eine Speicherzelle aufweist, einer Kondensatorladeeinrichtung (Q), die an den Kondensator angeschlossen ist und zum Aufladen des Kondensators bis zu einer ersten vorgegebenen Spannung (VDD) auf ein Zeitsignal hin dient, einem Inverter (40), der mit dem Ausgang der Leckstrom-Überwachungsschaltung verbunden ist, einem Auffrischungsadressenzähler (15), der mit der Ausgabe des Inverters betrieben wird, und einer Verzögerungsschaltung (41), die mit dem Ausgang des Inverters verbunden ist, um die Zeitsignale für den Kondensator zu erzeugen, wenn seine Spannung auf eine vorgegebene Höhe gefallen ist, wodurch die Frequenz der Pulse, die dem Auffrischungsadressenzähler von dem Inverter zugeführt werden, von der Entladungsgeschwindigkeit des Kondensators abhängig ist.

5. Dynamische Halbleiterspeicheranordnung nach Anspruch 3 oder 4, bei der die Inverterschaltung einen Inverter vom LadeEntlade-Typus aufweist.

Fig.1.

Fig.2.

FIG.3.

FIG.4.

OUTPUT OF
DELAY
CIRCUIT

$t_1$ $t_2$

POTENTIAL
OF NODE N

OUTPUT OF
INVERTER

$t_1$ $t_3$ *FIG.5.*

*FIG.6.*